(19) 

Europäisches
Patentamt
European
Patent Office
Office européen
des brevets

(11) **EP 4 711 784 A1**

(12) **EUROPEAN PATENT APPLICATION**
published in accordance with Art. 153(4) EPC

(43) Date of publication:
**18.03.2026 Bulletin 2026/12**

(21) Application number: 25749029.2

(22) Date of filing: **24.01.2025**

(51) International Patent Classification (IPC):
**G01R 31/374** (2019.01)     **G01R 31/382** (2019.01)
**G01R 31/396** (2019.01)     **G08B 21/18** (2006.01)
**B60L 58/10** (2019.01)

(52) Cooperative Patent Classification (CPC):
**G01R 31/374; B60L 58/16; G01R 31/3646;
G01R 31/367; G01R 31/3842; G01R 31/392;
G01R 31/396**

(86) International application number:
**PCT/KR2025/001517**

(87) International publication number:
**WO 2025/165126 (07.08.2025 Gazette 2025/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.01.2024 KR 20240014209**

(71) Applicant: **LG Energy Solution, Ltd.
Seoul 07335 (KR)**

(72) Inventors:
• **PAK, Seon-Ho**
  **Daejeon 34122 (KR)**
• **JEONG, Hee-Seok**
  **Daejeon 34122 (KR)**
• **CHA, A-Ming**
  **Daejeon 34122 (KR)**
• **BAE, Yoon-Jung**
  **Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **APPARATUS AND METHOD FOR DIAGNOSING BATTERY**

(57)     A battery diagnosing apparatus according to one embodiment of the present disclosure includes: a profile acquisition unit that acquires a charging profile representing a correspondence between a voltage and a current of a battery measured during a charging process; and a control unit that calculates a first constant current (CC) capacity and a first constant voltage (CV) capacity from the charging profile, calculates a capacity change rate for the first CC capacity and the first CV capacity based on a second CC capacity and a second CV capacity stored in advance, and diagnoses a state of the battery based on the calculated capacity change rate and a preset correction coefficient.

**FIG. 1**

**BATTERY DIAGNOSING APPARATUS** — 100
PROFILE ACQUISITION UNIT — 110
CONTROL UNIT — 120
STORAGE UNIT — 130

EP 4 711 784 A1

# Description

## TECHNICAL FIELD

This application is based on and claims priority from Korean Patent Application No. 10-2024-0014209 filed on January 30, 2024, with the Korean Intellectual Property Office, the disclosure of which is incorporated herein in its entirety by reference.

The present disclosure relates to a battery diagnosing apparatus and method, and more specifically, to a battery diagnosing apparatus and method for diagnosing the state of a battery.

## BACKGROUND

Recently, as the demand for portable electronic products such as notebook computers, video cameras, and portable telephones has rapidly increased, and as the development of electric vehicles, energy storage batteries, robots, and satellites has begun in earnest, researches on the high-performance batteries allowing repeated charging and discharging are actively underway.

Currently, commercialized batteries include, for example, nickel-cadmium batteries, nickel-hydrogen batteries, nickel-zinc batteries, and lithium batteries. Of these batteries, lithium batteries are gaining considerable attention due to their advantages including a substantially low memory effect to allow a high degree of freedom in charging and discharging, a very low self-discharging rate, and high energy density, as compared to nickel-based batteries.

While many studies are being conducted on the batteries focusing on the high-capacity and the high-density, it is also important to improve the lifespan and the safety of the batteries. In order to enhance the safety of batteries, a technology is necessary, which may accurately diagnose the current state of batteries.

## DISCLOSURE

### Technical Problem

The present disclosure provides a battery diagnosing apparatus and method that are capable of diagnosing the state of a battery based on the charge capacity of the battery.

Various aspects of the present disclosure may be understood through the following description and will become more apparent from the embodiments of the present disclosure. In addition, it will be readily understood that various aspects of the present disclosure may be implemented by the means and combinations thereof as described in the claims.

### Technical Solution

A battery diagnosing apparatus according to one aspect of the present disclosure may include: a profile acquisition unit configured to acquire a charging profile representing a correspondence between a voltage and a current of a battery measured during a charging process; and a control unit configured to calculate a first constant current (CC) capacity and a first constant voltage (CV) capacity from the charging profile, calculate a capacity change rate for the first CC capacity and the first CV capacity based on a second CC capacity and a second CV capacity stored in advance, and diagnose a state of the battery based on the calculated capacity change rate and a preset correction coefficient.

The control unit may be configured to calculate a CC capacity difference between the first CC capacity and the second CC capacity, calculate a CV capacity difference between the first CV capacity and the second CV capacity, and calculate a ratio of the CC capacity difference and the CV capacity difference, thereby obtaining the capacity change rate.

The control unit may be configured to calculate a decrease in the first CC capacity with respect to the second CC capacity as the CC capacity difference, and calculate an increase in the first CV capacity with respect to the second CV capacity as the CV capacity difference.

The control unit may be configured to calculate a correction change rate by multiplying the capacity change rate by the correction coefficient, compare the correction change rate with a threshold value set in advance, and diagnose the state of the battery based on a result of the comparison.

The control unit may be configured to diagnose the state of the battery as a normal state when the correction change rate is greater than or equal to the threshold value.

The control unit may be configured to diagnose the state of the battery as an abnormal state when the correction change rate is less than the threshold value.

The control unit may be configured to output a notification signal to notify a warning about sudden drop when the state of the battery is diagnosed as the abnormal state.

The correction coefficient may be preset based on an amount of change in CC capacity and an amount of change in CV capacity of the battery during a reference number of cycles set in advance.

The correction coefficient may be preset as a ratio of a representative amount of change in the CV capacity and a representative amount of change in the CC capacity during the reference number of cycles.

A battery pack according to another aspect of the present disclosure may include the battery diagnosing apparatus according to one embodiment of the present disclosure.

A vehicle according to yet another aspect of the present disclosure may include the battery diagnosing apparatus according to one embodiment of the present disclosure.

A battery diagnosing method according to still another aspect of the present disclosure may include: a profile acquisition step of acquiring a charging profile representing a correspondence between a voltage and a current of a battery measured during a charging process; a capacity calculation step of calculating a first constant current (CC) capacity and a first constant voltage (CV) capacity from the charging profile; a capacity change rate calculation step of calculating a capacity change rate for the first CC capacity and the first CV capacity based on a second CC capacity and a second CV capacity stored in advance; and a diagnosis step of diagnosing a state of the battery based on the calculated capacity change rate and a preset correction coefficient.

A non-transitory computer-readable storage medium according to still yet another aspect of the present disclosure may have stored therein a program that, when executed, caused a computer to perform a battery diagnosing method including: a profile acquisition step of acquiring a charging profile representing a correspondence between a voltage and a current of a battery measured during a charging process; a capacity calculation step of calculating a first constant current (CC) capacity and a first constant voltage (CV) capacity from the charging profile; a capacity change rate calculation step of calculating a capacity change rate for the first CC capacity and the first CV capacity based on a second CC capacity and a second CV capacity stored in advance; and diagnosis step of diagnosing a state of the battery based on the calculated capacity change rate and a preset correction coefficient.

Advantageous Effects

According to one aspect of the present disclosure, the battery diagnosing apparatus diagnoses the state of the battery from the CC capacity and the CV capacity using a correction coefficient, thereby enabling a non-destructive diagnosis of the state of the battery in a simple manner.

In addition, according to one aspect of the present disclosure, a battery with a high possibility of sudden drop may be detected early.

The effects of the present disclosure are not limited to those mentioned above, and other effects not mentioned will be clearly understood by those skilled in the art from the description of the claims.

BRIEF DESCRIPTION OF THE DRAWINGS

The following drawings attached hereto exemplify embodiments of the present disclosure and serve to further understand the technical idea of the present disclosure together with the detailed description of the disclosure to be described later. Therefore, the present disclosure should not be construed as being limited to the matters illustrated in the drawings.

FIG. 1 is a schematic diagram illustrating a battery diagnosing apparatus according to one embodiment of the present disclosure.
FIG. 2 is a schematic diagram illustrating a charging profile according to one embodiment of the present disclosure.
FIGS. 3 to 5 are schematic diagrams illustrating diagnosis results for the first to third batteries.
FIG. 6 is a schematic diagram illustrating a battery pack according to another embodiment of the present disclosure.
FIG. 7 is a schematic diagram illustrating a vehicle according to yet another embodiment of the present disclosure.
FIG. 8 is a schematic diagram illustrating a battery diagnosing method according to still another embodiment of the present disclosure.

DETAILED DESCRIPTION

Words and terms used in the detailed description and the claims herein should not be interpreted to be limited to their usual or dictionary meanings, but should be interpreted to have meanings and concepts that correspond to the technical idea of the present disclosure in compliance with the principle that inventors may appropriately define terms and concepts for the purpose of best describing the present disclosure.

Accordingly, it can be appreciated that the embodiments described herein and the configurations illustrated in the drawings are merely examples of the present disclosure, which do not exhaustively represent the technical idea of the present disclosure, and various equivalents and modifications may be made to substitute the present disclosure at the time of filing the present disclosure.

When describing the present disclosure, detailed description of related known configurations or functions may be omitted if determined to obscure the gist of the present disclosure.

Terms with ordinal numbers such as first, second and so on may be used to discriminate one of various components from the other, but should not be interpreted as limiting the components.

Throughout the descriptions herein, when a certain part "includes" a specific component, this description does not indicate that the certain part excludes other components, but indicates that the certain part may further include other components, unless otherwise defined.

Further, throughout the descriptions herein, when two components are "connected" to each other, this description indicates not only that the two components are "directly connected" to each other, but also that the two components are "indirectly connected" to each other via another component.

Hereinafter, embodiments of the present disclosure are described in detail with reference to the accompanying drawings.

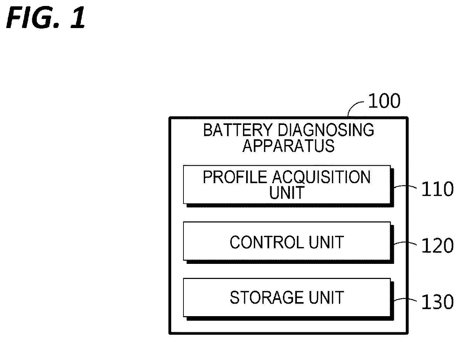

FIG. 1 is a schematic diagram illustrating a battery diagnosing apparatus 100 according to one embodiment of the present disclosure.

Referring to FIG. 1, the battery diagnosing apparatus 100 may include a profile acquisition unit 110 and a control unit 120.

Here, a battery subjected to information generation indicates a single isolated cell that is physically separable, and has a negative electrode terminal and a positive electrode terminal. For example, a lithium-ion battery or a lithium-polymer battery may be considered as the battery. The type of battery may be a cylindrical type, a prismatic type, or a pouch type. Further, the battery may indicate a battery bank, a battery module, or a battery pack, in which a plurality of cells is connected to each other in series and/or in parallel. Hereinafter, for the convenience of description, descriptions are made assuming that the battery indicates a single isolated cell.

The profile acquisition unit 110 may be configured to acquire a charging profile CP indicating a correspondence between the voltage and current of the battery measured during the charging process.

For example, the charging profile CP is a profile that represents a relationship between the voltage V and current C when the battery's state of charge (SOC) is charged from a preset charging start SOC, or 0%, to a preset charging end SOC, or 100%. For example, the charging profile CP represents a relationship between the charging voltage and charging current of the battery.

For example, there is no special limitation on a charging C-rate for generating a charging profile CP. However, in order to obtain a more accurate charging profile CP, the battery should be charged at a low rate. For example, a charging profile (CP) may be generated in the process of charging the battery at 0.05 C.

The profile acquisition unit 110 may acquire a battery profile BP in the following manner.

For example, the profile acquisition unit 110 may directly read or receive a charging profile CP of the battery from the outside. For example, the profile acquisition unit 110 may acquire a charging profile CP by being connected to the outside by wire and/or wirelessly and reading or receiving the charging profile CP.

In another example, the profile acquisition unit 110 may directly generate a charging profile CP based on battery information about the voltage and current of the battery. For example, the profile acquisition unit 110 may acquire a charging profile CP by directly generating the charging profile CP based on the battery information.

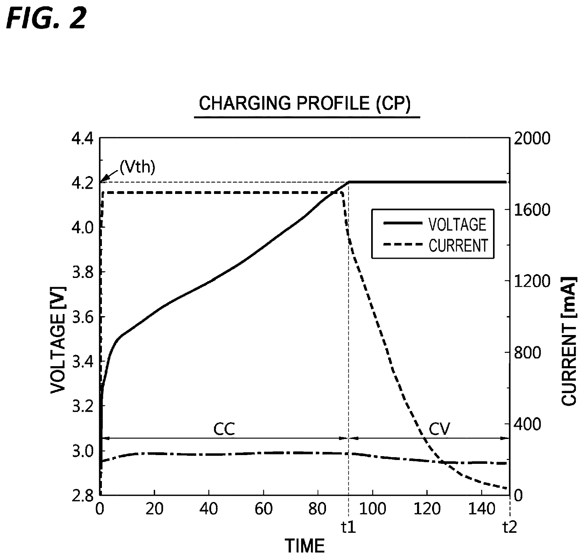

FIG. 2 is a schematic diagram illustrating a charging profile CP according to one embodiment of the present disclosure.

For example, in the embodiment of FIG. 2, the battery may be charged until the voltage of the battery reaches from 3.0 V to 4.2 V. For example, the battery may be charged with a constant current (CC) until a time point t1 when the voltage reaches a preset threshold voltage Vth, and may be charged with a constant voltage (CV) from the time point t1 until an end time point t2. Here, the threshold voltage Vth may also be called a cut-off voltage.

The profile acquisition unit 110 may be communicably connected to the control unit 120. For example, the profile acquisition unit 110 may be wired or wirelessly connected to the control unit 120. In an example, the profile acquisition unit 110 may transmit the acquired charging profile CP to the control unit 120. In another example, the control unit 120 may read the charging profile CP from the profile acquisition unit 110.

According to one embodiment, the control unit 120 may be configured to calculate a first CC capacity and a first CV capacity from the charging profile CP.

For example, the control unit 120 may calculate the first CC capacity and the first CV capacity of the battery from the charging profile CP using an ampere counting method or a coulomb counting method. Here, the first CC capacity is a charging capacity while the battery is charged with CC, and the first CV capacity is a charging capacity while the battery is charged with CV.

For example, in the embodiment of FIG. 2, the control unit 120 may calculate the first CC capacity by calculating the current amount at the time points 0 to t1. In addition, the control unit 120 may calculate the first CV capacity by calculating the current amount at the time points t1 to t2.

The control unit 120 may be configured to calculate a capacity change rate for the first CC capacity and the first CV capacity based on a second CC capacity and a second CV capacity that are stored in advance.

For example, the second CC capacity is a CC capacity of the battery that is stored in advance, and means the CC capacity of the battery calculated at a previous time point. Similarly, the second CV capacity is a CV capacity of the battery that is stored in advance, and means the CV capacity of the battery calculated at a previous time point. For example, it is assumed that the present is the nth cycle (where n is a natural number greater than or equal to 2). The control unit 120 may calculate the first CC capacity and the first CV capacity in the nth cycle. In addition, the CC capacity calculated in the (n-1)th cycle may be the second CC capacity stored in advance, and the CV capacity calculated in the (n-1)th cycle may be the second CV capacity stored in advance. In this embodiment, it is described that the cycle in which the second CC capacity and the second CV capacity are calculated (the (n-1)th cycle) and the cycle in which the first CC capacity and the first CV capacity are calculated (the nth cycle) are one cycle apart, but it should be noted that the cycle gap may change depending on the battery diagnosis cycle, diagnosis conditions, or diagnosis method.

For example, the control unit 120 may be configured to calculate the CC capacity difference between the first CC capacity and the second CC capacity.

The CC capacity may decrease as the battery deteriorates. Since the second CC capacity is calculated before the first CC capacity, the second CC capacity may be greater than the first CC capacity. Therefore, the control unit 120 may be configured to calculate the decrease in the first CC capacity with respect to the second CC capacity as a CC capacity difference. For example, the control unit 120 may calculate the CC capacity difference by calculating the formula of "the second CC capacity - the first CC capacity."

Additionally, the control unit 120 may be configured to calculate the CV capacity difference between the first CV capacity and the second CV capacity.

The CV capacity may increase as the battery deteriorates. Since the second CV capacity is calculated before the first CV capacity, the second CV capacity may be less than or equal to the first CV capacity. Therefore, the control unit 120 may be configured to calculate the increase in the first CV capacity with respect to the second CV capacity as a CV capacity difference. For example, the control unit 120 may calculate the CV capacity difference by calculating the formula of "the second CV capacity - the first CV capacity."

Finally, the control unit 120 may be configured to calculate a ratio of the CC capacity difference and the CV capacity difference to calculate the capacity change rate.

For example, the control unit 120 may calculate the ratio of the CV capacity difference to the CC capacity difference to calculate the capacity change rate. For example, the control unit 120 may calculate the formula of "the CV capacity difference ÷ the CC capacity difference" to calculate the capacity change rate.

In another example, the control unit 120 may calculate the ratio of the CC capacity difference to the CV capacity difference to calculate the capacity change rate. For example, the control unit 120 may calculate the formula of "the CC capacity difference ÷ the CV capacity difference" to calculate the capacity change rate.

Hereinafter, for the convenience of explanation, it is assumed that the capacity change rate is a ratio of the CV capacity difference to the CC capacity difference.

The control unit 120 may be configured to diagnose the state of the battery based on the calculated capacity change rate and the preset correction coefficient.

For example, the control unit 120 may be configured to calculate the correction change rate by multiplying the capacity change rate by the correction coefficient. For example, the correction change rate is a value obtained by multiplying the capacity change rate by the correction coefficient.

For example, the control unit 120 may calculate the correction change rate using Equation 1 below:

[Equation 1]

$$CC_n = \frac{QV_n - QV_{n-1}}{QC_{n-1} - QC_n} \times \alpha$$

Here, n is a natural number greater than or equal to 2 and is a factor representing a cycle time point. CCn is a correction change rate of the nth cycle, QVn is a first CV capacity of the nth cycle, and QVn-1 is a second CV capacity of the nth cycle. QCn is a first CC capacity of the nth cycle, QCn-1 is a second CC capacity of the n-1th cycle, and α is a correction coefficient. In addition, the capacity change rate is "(QVn-QVn-1)÷(QCn-1-QCn)."

In addition, the correction coefficient may be preset based on an amount of change in CC capacity and an amount of change in CV capacity of the battery during a reference number of cycles set in advance.

For example, the correction coefficient may be preset as a ratio of a representative amount of change in the CV capacity and a representative amount of change in the CC capacity during the reference number of cycles.

The correction coefficient may be set for a battery in the beginning of life (BOL) state. According to one embodiment, the correction coefficient may be set based on a representative change amount of CV capacity and a representative change amount of CC capacity during a reference number of cycles from the first cycle of the battery. Here, the representative change amount may be a minimum change amount, a maximum change amount, an average change amount, or a middle change amount.

For example, it is assumed that the preset reference number of times is 10 and the representative change amount is the average change amount. The change amount of CV capacity and the change amount of CC capacity from the 1st cycle (the initial cycle) to the 10th cycle of the battery may be calculated. Here, since the change amount of CV capacity and the change amount of CV capacity are calculated for each cycle from the 2nd cycle, a total of 9 changes in CV capacity and changes in CC capacity may be calculated. The average value of the 9 changes in CV capacity may be set as the representative change amount of CV capacity, and the average value of the 9 changes in CC capacity may be set as the representative change amount of CC capacity. In addition, the correction coefficient may be set according to the ratio of the average value of the change amount of CV capacity and the average value of the change amount of CC capacity.

For example, the correction coefficient may be preset according to Equation 2 below.

[Equation 2]

$$\alpha = \frac{dQC_{ref}}{dQV_{ref}}$$

Here, $\alpha$ is a correction coefficient, dQCref is a representative change in CC capacity, and dQVref is a representative change in CV capacity.

The control unit 120 may be configured to compare the correction change rate with a preset threshold value th and diagnose the state of the battery based on the comparison result.

For example, the control unit 120 may compare the magnitude of the correction change rate and the threshold value th. Here, the threshold value th is a measure that distinguishes the state of the battery as a normal state or an abnormal state based on the correction change rate.

For example, the control unit 120 may diagnose the state of the battery as a normal state when the correction change rate is greater than or equal to the threshold value th. In another example, the control unit 120 may be configured to diagnose the state of the battery as an abnormal state when the correction change rate is less than the threshold value th.

Theoretically, when the CC capacity decreases as the battery deteriorates, the CV capacity should increase by the amount of decrease. However, in practice, when the battery deteriorates, the CV capacity does not increase by the amount of decrease in the CC capacity. Therefore, the control unit 120 corrects the capacity change rate calculated for the nth cycle and the (n-1)th cycle by a correction coefficient, and determines whether the battery deterioration is normal or abnormal based on the corrected change rate.

For example, it is assumed that the average change amount (average decrease amount) of the CC capacity is 1, the average change amount (average increase amount) of the CV capacity is 0.5, and the threshold value th is set to 1. In this case, according to Equation 2, the correction coefficient may be preset to 2. The control unit 120 may diagnose the state of the battery as a normal state when the correction change rate calculated by multiplying the capacity change rate and the correction coefficient is 1 or more. Meanwhile, the control unit 120 may diagnose the state of the battery as an abnormal state when the correction change rate is less than 1.

When the correction change rate multiplied by the correction coefficient is less than the threshold value th, the balance of the decrease amount of the CC capacity and the increase amount of the CV capacity is significantly broken. Therefore, the control unit 120 may diagnose the state of the battery as a abnormal state in this case.

The battery diagnosing apparatus 100 diagnoses the state of the battery from the CC capacity and the CV capacity using a correction coefficient, thereby enabling a non-destructive diagnosis of the state of the battery in a simple manner.

Meanwhile, the profile acquisition unit 110 and the control unit 120 equipped in the battery diagnosing apparatus 100 may optionally include a processor, an application-specific integrated circuit (ASIC), another chipset, a logic circuit, a register, a communication modem, and a data processing device known in the art to execute various control logics performed in the present disclosure. In addition, when the control logic is implemented as software, the profile acquisition unit 110 and the control unit 120 may be implemented as a set of program modules. At this time, the program modules may be stored in a memory and executed by the profile acquisition unit 110 and the control unit 120. The memory may be located inside or outside the profile acquisition unit 110 and the control unit 120, and may be connected to the profile acquisition unit 110 and the control unit 120 by various well-known means.

In addition, the battery diagnosing apparatus 100 may further include a storage unit 130. The storage unit 130 may store data or programs required for each component of the battery diagnosing apparatus 100 to perform operations and functions, or data generated in the process of performing operations and functions. The storage unit 130 is not particularly limited in its type as long as it is a known information storage means known to be able to record, erase, update, and read data. In an example, the information storage means may include a random access memory (RAM), a flash memory, a read-only memory (ROM), an electronically erasable programmable read-only memory (EEPROM), and a register. In addition, the storage unit 130 may store program codes in which processes executable by the profile acquisition unit 110 and the control unit 120 are defined.

For example, the storage unit 130 may store battery information, a charging profile CP, and battery diagnosis information by the control unit 120.

The control unit 120 may be configured to output a notification signal to notify a warning about sudden drop when the state of the battery is diagnosed as the abnormal state.

For example, a battery diagnosed as an abnormal state has a greater rate of decrease in CC capacity than a rate of increase in CV capacity. For example, a battery diagnosed as an abnormal state may have a rapidly deteriorating lifespan. Therefore, it can be said that a battery diagnosed as an abnormal state has a very high possibility of experiencing a sudden drop at an unexpected moment.

When the battery is installed and used in a device such as a bicycle, motorcycle, vehicle, drone, or energy storage system (ESS), the device may turn off when the battery suddenly drops. For example, when the battery suddenly drops, the vehicle or other transportation device may turn off, which may result in personal injury, and when the device such as a drone turns off, financial damage including damage and/or loss of the device may occur. In addition, the damages to such devices may also result in personal injury.

Accordingly, the battery diagnosing apparatus 100 may suppress unexpected accidents caused by sudden drops of the battery in advance by determining the possibility of sudden drops of the battery based on the CC capacity and CV capacity that may be readily obtained from the charging profile CP. In addition, the battery diagnosing apparatus 100 may provide a warning for a battery with a high possibility of sudden drops by externally outputting a notification signal regarding the diagnosis result.

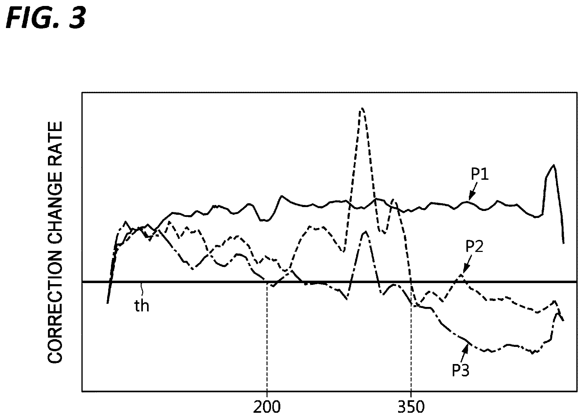

FIGS. 3 to 5 are schematic diagrams illustrating diagnosis results for the first to third batteries.

For example, the first battery is a battery designed to deteriorate slowly as the cycle progresses, the second battery is a battery designed to deteriorate at a normal level as the cycle progresses, and the third battery is a battery designed to deteriorate rapidly as the cycle progresses.

In the embodiment of FIG. 3, the first profile P1 is a profile representing a cycle-by-cycle correction change rate for the first battery, the second profile P2 is a profile representing a cycle-by-cycle correction change rate for the second battery, and the third profile P3 is a profile representing a cycle-by-cycle correction change rate for the third battery.

The control unit 120 may diagnose the state of the batteries by comparing the cycle-by-cycle correction change rates of the first to third batteries with a preset threshold value th. The first battery may be diagnosed as a normal state throughout the cycle, the second battery may be diagnosed as an abnormal state for the first time at the 350th cycle, and the third battery may be diagnosed as an abnormal state for the first time at the 200th cycle.

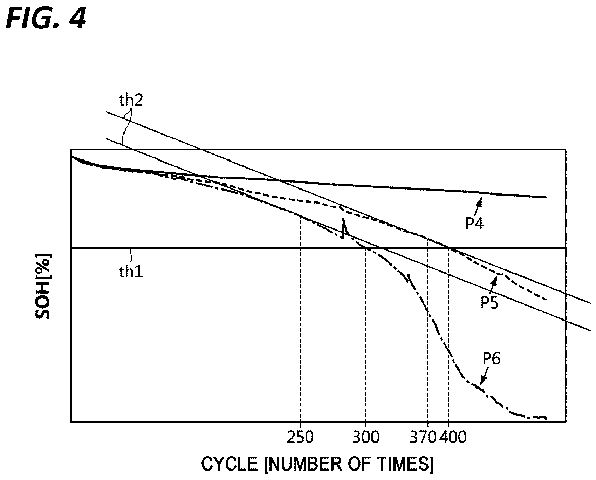

In the embodiment of FIG. 4, the fourth profile P4 is a profile representing a cycle-by-cycle state of health (SOH) for the first battery, the fifth profile P5 is a profile representing a cycle-by-cycle SOH for the second battery, and the sixth profile P6 is a profile representing a cycle-by-cycle SOH for the third battery.

The control unit 120 may diagnose the state of the batteries by comparing the cycle-by-cycle SOH of the first to third batteries with a preset first threshold value th1. Here, the first threshold value th1 may be preset as a reference SOH that may distinguish the state of the battery as a normal state or an abnormal state. The first battery may be diagnosed as a normal state throughout the cycle, the second battery may be diagnosed as an abnormal state for the first time at the 400th cycle, and the third battery may be diagnosed as an abnormal state for the first time at the 300th cycle.

According to one embodiment, the control unit 120 may diagnose the state of the batteries by comparing a cycle-by-cycle SOH change rate of the first to third batteries with a preset second threshold value th2. Here, the second threshold value th2 may be preset as a reference SOH change rate that may distinguish the state of the battery as a normal state or an abnormal state. The first battery may be diagnosed as a normal state throughout the cycle, the second battery may be diagnosed as an abnormal state for the first time at the 370th cycle, and the third battery may be diagnosed as an abnormal state for the first time at the 250th cycle.

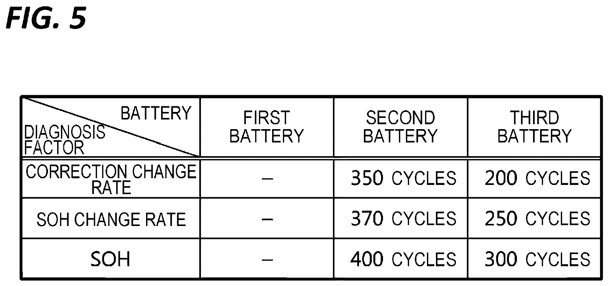

Referring to FIG. 5, when diagnosing the state of the battery based on the correction change rate among the correction change rate, SOH, and SOH change rate, it can be confirmed that the cycle that is first diagnosed as an abnormal state is the earliest. Therefore, according to one embodiment of the present disclosure, a battery with a high possibility of sudden drop may be detected early.

The battery diagnosing apparatus 100 according to the present disclosure may be applied to a battery management system (BMS). For example, the BMS according to the present disclosure may include the battery diagnosing apparatus 100 described above. With the configuration, at least some of the components of the battery diagnosing apparatus 100 may be implemented by supplementing or adding the functions of the components included in the conventional BMS. For example, the profile acquisition unit 110, the control unit 120, and the storage unit 130 of the battery diagnosing apparatus 100 may be implemented as components of the BMS.

In addition, the battery diagnosing apparatus 100 according to the present disclosure may be equipped in a battery pack. In addition, the battery pack according to the present disclosure may include the battery diagnosing apparatus 100 described above and one or more battery cells. In addition, the battery pack may further include, for example, electrical components (e.g., relays and fuses) and a case.

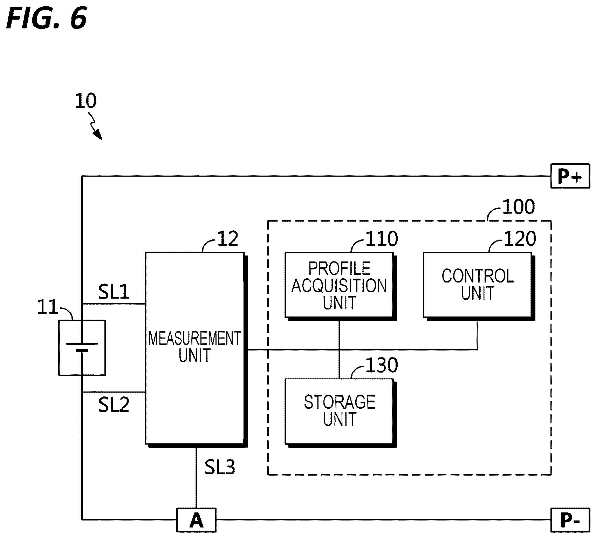

FIG. 6 is a schematic diagram illustrating a battery pack 10 according to another embodiment of the present disclosure.

The positive terminal of the battery 11 may be connected to the positive terminal P+ of the battery pack 10, and the negative terminal of the battery 11 may be connected to the negative terminal P- of the battery pack 10.

A measurement unit 12 may be connected to a first sensing line SL1, a second sensing line SL2, and a third sensing line SL3. For example, the measurement unit 12 may be connected to the positive terminal of the battery 11 through the first sensing line SL1, and to the negative terminal of the battery 11 through the second sensing line SL2. The measurement unit 12 may measure the voltage of the battery 11 based on the voltage measured at each of the first sensing line SL1 and the second sensing line SL2.

Then, the measurement unit 12 may be connected to a current measurement unit A through the third sensing line SL3. For example, the current measurement unit A may be an ammeter or a shunt resistor capable of measuring the charging current and the discharging cur-

ent of the battery 11. The measurement unit 12 may measure the charging current of the battery 11 through the third sensing line SL3 to calculate the charging amount. In addition, the measurement unit 12 may measure the discharging current of the battery 11 through the third sensing line SL3 to calculate the discharging amount.

For example, the profile acquisition unit 110 may read or receive battery information about the voltage and current of the battery from the measurement unit 12. And, the profile acquisition unit 110 may generate a charging profile CP based on the battery information.

In another example, the profile acquisition unit 110 may read or receive a charging profile CP from the measurement unit 12.

An external device may be connected to the positive terminal P+ and the negative terminal P- of the battery pack 10. For example, the external device may be a charging device or a load. And, the positive terminal of the battery 11, the positive terminal P+ of the battery pack 10, the external device, the negative terminal P- of the battery pack 10, and the negative terminal of the battery 11 may be electrically connected.

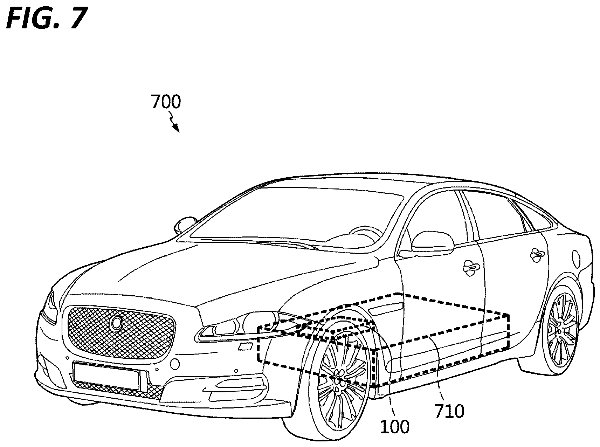

FIG. 7 is a schematic diagram illustrating a vehicle 700 according to another embodiment of the present disclosure.

Referring to FIG. 7, a battery pack 710 according to an embodiment of the present disclosure may be included in the vehicle 700, such as an electric vehicle (EV) or a hybrid vehicle (HV). In addition, the battery pack 710 may drive the vehicle 700 by supplying power to a motor through an inverter equipped in the vehicle 700. Here, the battery pack 710 equipped in the vehicle may include the battery diagnosing apparatus 100 according to an embodiment of the present disclosure. In this case, the battery diagnosing apparatus 100 may be an on-board apparatus included in the vehicle 700.

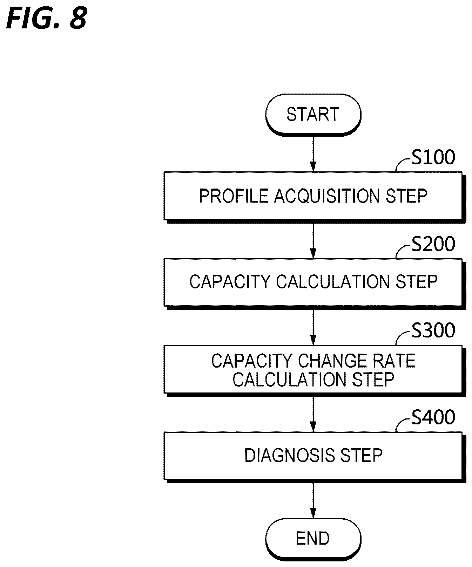

FIG. 8 is a schematic diagram illustrating a battery diagnosing method according to still another embodiment of the present disclosure.

Referring to FIG. 8, the battery diagnosing method may include a profile acquisition step (S100), a capacity calculation step (S200), a capacity change rate calculation step (S300), and a diagnosis step (S400).

For example, each step of the battery diagnosing method may be performed by the battery diagnosing apparatus 100. In the following, for the convenience of explanation, any content that overlaps with the previously described content will be omitted or briefly described.

The profile acquisition step (S100) is a step of acquiring a charging profile CP that represents a correspondence between the voltage and current of the battery measured during the charging process, and may be performed by the profile acquisition unit 110.

For example, the profile acquisition unit 110 may directly read or receive a charging profile CP of the battery from the outside. For example, the profile acquisition unit 110 may acquire a charging profile CP by being connected to the outside by wire and/or wirelessly and reading or receiving the charging profile CP.

In another example, the profile acquisition unit 110 may generate a charging profile CP based on battery information about the voltage and current of the battery. For example, the profile acquisition unit 110 may acquire a charging profile CP by directly generating the charging profile CP based on the battery information.

The capacity calculation step (S200) is a step of calculating the first CC capacity and the first CV capacity from the charging profile CP, and may be performed by the control unit 120.

According to one embodiment, the control unit 120 may calculate the first CC capacity and the first CV capacity of the battery from the charging profile CP using an ampere counting method or a coulomb counting method.

The capacity change rate calculation step (S300) is a step of calculating the capacity change rate for the first CC capacity and the first CV capacity based on the pre-stored second CC capacity and the pre-stored second CV capacity, and may be performed by the control unit 120.

According to one embodiment, the control unit 120 may calculate the CC capacity difference between the first CC capacity and the second CC capacity, calculate the CV capacity difference between the first CV capacity and the second CV capacity, and calculate the ratio of the CC capacity difference and the CV capacity difference, thereby calculating the capacity change rate.

The diagnosis step S400 is a step of diagnosing the state of the battery based on the calculated capacity change rate and a preset correction coefficient, and may be performed by the control unit 120.

For example, the control unit 120 may calculate the correction change rate by multiplying the capacity change rate by the correction coefficient. Then, the control unit 120 may diagnose the state of the battery as a normal state when the correction change rate is greater than or equal to the threshold value th. Meanwhile, the control unit 120 may diagnose the state of the battery as an abnormal state when the correction change rate is less than the threshold value th.

The embodiments of the present disclosure described above may be implemented not only by an apparatus and method, but also by programs implementing functions corresponding to the components of the embodiments of the present disclosure or by a recording medium that stores the programs. This implementation may readily be achieved by one skilled in the art to which the present disclosure belongs, from the descriptions of the embodiments above.

While the present disclosure has been described using limited embodiments and drawings, the present disclosure is not limited thereto, and it may be appreciated that various modifications and changes may be made by those having ordinary skill in the art of the present disclosure within the technical idea of the present disclosure and the equitable scope of the claims set forth below.

Further, since various substitutions, modifications, and changes may be made by those having ordinary skill in the art of the present disclosure within the scope that does not depart from the technical idea of the present disclosure, the present disclosure described above is not limited by the foregoing embodiments and the accompanying drawings, but all or portions of the embodiments may be selectively combined to implement various modifications.

(Description of Symbols)

     10: battery pack
     11: battery
     12: measurement unit
     100: battery diagnosing apparatus
     110: profile acquisition unit
     120: control unit
     130: storage unit
     700: vehicle
     710: battery pack

**Claims**

1. A battery diagnosing apparatus comprising:

   a profile acquisition unit configured to acquire a charging profile representing a correspondence between a voltage and a current of a battery measured during a charging process; and
   a control unit configured to calculate a first constant current (CC) capacity and a first constant voltage (CV) capacity from the charging profile, calculate a capacity change rate for the first CC capacity and the first CV capacity based on a second CC capacity and a second CV capacity stored in advance, and diagnose a state of the battery based on the calculated capacity change rate and a correction coefficient set in advance.

2. The battery diagnosing apparatus according to claim 1, wherein the control unit is configured to calculate a CC capacity difference between the first CC capacity and the second CC capacity, calculate a CV capacity difference between the first CV capacity and the second CV capacity, and calculate a ratio of the CC capacity difference and the CV capacity difference, thereby obtaining the capacity change rate.

3. The battery diagnosing apparatus according to claim 2, wherein the control unit is configured to calculate a decrease in the first CC capacity with respect to the second CC capacity as the CC capacity difference, and calculate an increase in the first CV capacity with respect to the second CV capacity as the CV capacity difference.

4. The battery diagnosing apparatus according to claim 1, wherein the control unit is configured to calculate a correction change rate by multiplying the capacity change rate by the correction coefficient, compare the correction change rate with a threshold value set in advance, and diagnose the state of the battery based on a result of the comparison.

5. The battery diagnosing apparatus according to claim 4, wherein the control unit is configured to:

   diagnose the state of the battery as a normal state when the correction change rate is greater than or equal to the threshold value, and
   diagnose the state of the battery as an abnormal state when the correction change rate is less than the threshold value.

6. The battery diagnosing apparatus according to claim 5, wherein the control unit is configured to output a notification signal to notify a warning about sudden drop when the state of the battery is diagnosed as the abnormal state.

7. The battery diagnosing apparatus according to claim 1, wherein the correction coefficient is preset based on an amount of change in CC capacity and an amount of change in CV capacity of the battery during a reference number of cycles set in advance.

8. The battery diagnosing apparatus according to claim 7, wherein the correction coefficient is preset as a ratio of a representative amount of change in the CV capacity and a representative amount of change in the CC capacity during the reference number of cycles.

9. A battery pack comprising the battery diagnosing apparatus according to any one of claims 1 to 8.

10. A vehicle comprising the battery diagnosing apparatus according to any one of claims 1 to 8.

11. A battery diagnosing method comprising:

   a profile acquisition step of acquiring a charging profile representing a correspondence between a voltage and a current of a battery measured during a charging process;
   a capacity calculation step of calculating a first constant current (CC) capacity and a first constant voltage (CV) capacity from the charging profile;

a capacity change rate calculation step of calculating a capacity change rate for the first CC capacity and the first CV capacity based on a second CC capacity and a second CV capacity stored in advance; and
a diagnosis step of diagnosing a state of the battery based on the calculated capacity change rate and a preset correction coefficient.

12. A non-transitory computer-readable storage medium having stored therein a program that, when executed, causes a computer to execute a battery diagnosing method comprising:

a profile acquisition step of acquiring a charging profile representing a correspondence between a voltage and a current of a battery measured during a charging process;
a capacity calculation step of calculating a first constant current (CC) capacity and a first constant voltage (CV) capacity from the charging profile;
a capacity change rate calculation step of calculating a capacity change rate for the first CC capacity and the first CV capacity based on a second CC capacity and a second CV capacity stored in advance; and
a diagnosis step of diagnosing a state of the battery based on the calculated capacity change rate and a preset correction coefficient.

FIG. 1

BATTERY DIAGNOSING APPARATUS — 100

PROFILE ACQUISITION UNIT — 110

CONTROL UNIT — 120

STORAGE UNIT — 130

## FIG. 2

### CHARGING PROFILE (CP)

# *FIG. 3*

# FIG. 4

## FIG. 5

| BATTERY DIAGNOSIS FACTOR | FIRST BATTERY | SECOND BATTERY | THIRD BATTERY |
|---|---|---|---|
| CORRECTION CHANGE RATE | — | 350 CYCLES | 200 CYCLES |
| SOH CHANGE RATE | — | 370 CYCLES | 250 CYCLES |
| SOH | — | 400 CYCLES | 300 CYCLES |

**FIG. 6**

# FIG. 7

# FIG. 8

```
                    ┌──────────┐
                    │  START   │
                    └────┬─────┘
                         │          ⌐S100
            ┌────────────▼─────────────┐
            │  PROFILE ACQUISITION STEP │
            └────────────┬─────────────┘
                         │          ⌐S200
            ┌────────────▼─────────────┐
            │ CAPACITY CALCULATION STEP │
            └────────────┬─────────────┘
                         │          ⌐S300
            ┌────────────▼─────────────┐
            │   CAPACITY CHANGE RATE   │
            │     CALCULATION STEP     │
            └────────────┬─────────────┘
                         │          ⌐S400
            ┌────────────▼─────────────┐
            │      DIAGNOSIS STEP      │
            └────────────┬─────────────┘
                         │
                    ┌────▼─────┐
                    │   END    │
                    └──────────┘
```

## INTERNATIONAL SEARCH REPORT

| International application No. |
| --- |
| **PCT/KR2025/001517** |

**A. CLASSIFICATION OF SUBJECT MATTER**

**G01R 31/374**(2019.01)i; **G01R 31/382**(2019.01)i; **G01R 31/396**(2019.01)i; **G08B 21/18**(2006.01)i; **B60L 58/10**(2019.01)i

According to International Patent Classification (IPC) or to both national classification and IPC

**B. FIELDS SEARCHED**

Minimum documentation searched (classification system followed by classification symbols)

G01R 31/374(2019.01); G01R 31/36(2006.01); G01R 31/367(2019.01); G01R 31/396(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), CC 용량(Constant Current capacity), CV 용량(Constant Voltage capacity), 변화율(change rate), 보정 계수(correction factor)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2618037 B1 (LG ENERGY SOLUTION, LTD.) 27 December 2023 (2023-12-27)<br>See paragraphs [0040]-[0180] and figures 2-11. | 1-12 |
| A | US 2023-0015318 A1 (SOUTHWEST RESEARCH INSTITUTE) 19 January 2023 (2023-01-19)<br>See paragraphs [0012]-[0027] and figures 1-4. | 1-12 |
| A | KR 10-2021-0150217 A (LG ENERGY SOLUTION, LTD.) 10 December 2021 (2021-12-10)<br>See paragraphs [0040]-[0120] and figures 3-7. | 1-12 |
| A | KR 10-2022-0067328 A (LG ENERGY SOLUTION, LTD.) 24 May 2022 (2022-05-24)<br>See paragraphs [0030]-[0131] and figures 2-6. | 1-12 |
| A | KR 10-2020-0140093 A (SAMSUNG SDI CO., LTD. et al.) 15 December 2020 (2020-12-15)<br>See paragraphs [0036]-[0099] and figures 1-4. | 1-12 |

☐ Further documents are listed in the continuation of Box C.      ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **12 May 2025** | **12 May 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2025/001517**

| Patent document cited in search report | | | Publication date (day/month/year) | Patent family member(s) | | | Publication date (day/month/year) |
|---|---|---|---|---|---|---|---|
| KR | 10-2618037 | B1 | 27 December 2023 | CN | 118475846 | A | 09 August 2024 |
| | | | | EP | 4428553 | A1 | 11 September 2024 |
| | | | | JP | 2024-546692 | A | 26 December 2024 |
| | | | | WO | 2023-249298 | A1 | 28 December 2023 |
| US | 2023-0015318 | A1 | 19 January 2023 | US | 11901759 | B2 | 13 February 2024 |
| KR | 10-2021-0150217 | A | 10 December 2021 | CN | 114270204 | A | 01 April 2022 |
| | | | | CN | 114270204 | B | 03 May 2024 |
| | | | | EP | 4063883 | A1 | 28 September 2022 |
| | | | | EP | 4063883 | B1 | 09 October 2024 |
| | | | | JP | 2022-544981 | A | 24 October 2022 |
| | | | | JP | 7331326 | B2 | 23 August 2023 |
| | | | | US | 12044744 | B2 | 23 July 2024 |
| | | | | US | 2023-0333174 | A1 | 19 October 2023 |
| | | | | WO | 2021-246655 | A1 | 09 December 2021 |
| KR | 10-2022-0067328 | A | 24 May 2022 | CN | 115917335 | A | 04 April 2023 |
| | | | | EP | 4155743 | A1 | 29 March 2023 |
| | | | | JP | 2023-515842 | A | 14 April 2023 |
| | | | | JP | 7443648 | B2 | 06 March 2024 |
| | | | | US | 2023-0176128 | A1 | 08 June 2023 |
| | | | | WO | 2022-108344 | A1 | 27 May 2022 |
| KR | 10-2020-0140093 | A | 15 December 2020 | EP | 3748380 | A1 | 09 December 2020 |
| | | | | EP | 3748380 | B1 | 04 May 2022 |
| | | | | US | 11293987 | B2 | 05 April 2022 |
| | | | | US | 2020-0386819 | A1 | 10 December 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• KR 1020240014209